(19) Europäisches Patentamt
European Patent Office
Office européen des brevets

(11) **EP 2 284 909 A1**

(12) **EUROPEAN PATENT APPLICATION**
published in accordance with Art. 153(4) EPC

(43) Date of publication:
**16.02.2011 Bulletin 2011/07**

(21) Application number: **09735208.2**

(22) Date of filing: **16.04.2009**

(51) Int Cl.:
*H01L 31/042* (2006.01)    *C09J 7/02* (2006.01)
*C09J 121/00* (2006.01)    *C09J 133/04* (2006.01)

(86) International application number:
**PCT/JP2009/001754**

(87) International publication number:
**WO 2009/130867 (29.10.2009 Gazette 2009/44)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **24.04.2008 JP 2008113802**

(71) Applicant: **Nitto Denko Corporation**
**Ibaraki-shi**
**Osaka 567-8680 (JP)**

(72) Inventors:
• **HONDA, Makoto**
**Ibaraki-shi**
**Osaka 567-8680 (JP)**
• **MAEDA, Kazuhisa**
**Ibaraki-shi**
**Osaka 567-8680 (JP)**

(74) Representative: **Grünecker, Kinkeldey,**
**Stockmair & Schwanhäusser**
**Anwaltssozietät**
**Leopoldstrasse 4**
**80802 München (DE)**

(54) **ADHESIVE SHEET FOR SOLAR CELL PANEL, SOLAR CELL PANEL USING THE ADHESIVE SHEET, AND METHOD FOR MANUFACTURING A SOLAR CELL PANEL USING THE ADHESIVE SHEET**

(57) A pressure-sensitive adhesive sheet for a solar panel according to the present invention is a pressure-sensitive adhesive sheet for use to seal silicon cells and includes a fluorine-containing resin film base and, on at least one side thereof, a pressure-sensitive adhesive layer. The pressure-sensitive adhesive sheet for a solar panel according to the present invention, when used to seal silicon cells, enables the manufacture of a solar panel with improved productivity and workability, while avoiding problems caused by vacuum hot pressing, such as damage to the wiring and process contamination due to squeezing out of the sealing resin.

Fig. 1

**Description**

Technical Field

The present invention relates to a pressure-sensitive adhesive sheet for a solar panel. More specifically, the present invention relates to a pressure-sensitive adhesive sheet which is advantageously used for sealing silicon cells (thin-film silicon solar cells) in a thin-film silicon solar panel.

Background Art

Thin-film silicon solar cells are now receiving attention, because they use less amounts of silicon than customary crystalline silicon solar cells do. A solar panel using such thin-film silicon solar cells is prepared, for example, by forming silicon cells on a glass substrate, sealing the silicon cells typically with an ethylene- vinyl acetate (EVA) resin, and further providing a back sheet. Next, the solar panel is incorporated into a frame to form a solar cell module (see, for example, Patent Literature (PTL) 1).

However, the sealing typically with an EVA resin in the manufacturing process of the solar panel is performed through pressing with heating under vacuum (vacuum hot pressing), and this causes problems in productivity and workability. For example, the heating damages the wiring, and/or the EVA resin squeezes out as a result of vacuum hot pressing and contaminates the process. In addition, the manufacturing process requires large-scaled heating facilities, to cause higher cost.

Citation List

Patent Literature

PTL 1: Japanese Unexamined Patent Application Publication (JP-A) No. 2003-110128

Summary of Invention

Technical Problem

An object of the present invention is to solve the above problems and to provide a pressure-sensitive adhesive sheet which is adopted to a solar panel without problems such as damage to the wiring by heating and contamination of the process due to squeezing off of the sealing resin and which thereby helps the solar panel to be manufactured with improved productivity and workability.

Solution to Problem

After intensive investigations to achieve the object, the present inventors have found that the use of a pressure-sensitive adhesive sheet including a fluorine-containing resin film base and a pressure-sensitive adhesive layer present on at least one side of the film base enables the manufacture of a solar panel while avoiding the wiring damage and the process contamination both caused by vacuum hot pressing. The present invention has been made based on these findings.

Specifically, the present invention provides, in an embodiment, a pressure-sensitive adhesive sheet for a solar panel, adopted to the sealing of a silicon cell in the solar panel, the pressure-sensitive adhesive sheet comprising a fluorine-containing resin film base and a pressure-sensitive adhesive layer present on at least one side of the film base.

The present invention provides, in another embodiment, the pressure-sensitive adhesive sheet for a solar panel, in which the pressure-sensitive adhesive layer includes an acrylic pressure-sensitive adhesive and/or a rubber pressure-sensitive adhesive.

The present invention further provides, in yet another embodiment, the pressure-sensitive adhesive sheet for a solar panel, in which the pressure-sensitive adhesive layer is a bubble-containing pressure-sensitive adhesive layer containing bubbles and/or hollow microspheres.

In still another embodiment, the present invention provides a solar panel comprising the pressure-sensitive adhesive sheet for a solar panel sealing a silicon cell, the silicon cell formed on a glass substrate.

The present invention provides, in another embodiment, a method for manufacturing a solar panel. This method includes the step of sealing a silicon cell present on a glass substrate with the pressure-sensitive adhesive sheet for a solar panel.

Advantageous Effects of Invention

The pressure-sensitive adhesive sheet for a solar panel according to the present invention includes a fluorine-containing resin base film and a pressure-sensitive adhesive layer present on at least one side of the base film, is used to seal silicon cells and whereby enables the manufacture of a solar panel while avoiding the damage to wiring and the process contamination both caused by vacuum hot pressing. In a preferred embodiment, a bubble-containing acrylic or rubber pressure-sensitive adhesive layer is used as the pressure-sensitive adhesive layer. This gives a pressure-sensitive adhesive sheet for a solar panel, which sheet has high adhesiveness and excellent fittability around bumps, thereby shows satisfactory sealing properties, and has good weatherability.

Brief Description of Drawings

[Fig. 1] Fig. 1 is a schematic cross-sectional view of an exemplary solar panel which includes silicon cells sealed with a pressure-sensitive adhesive sheet for a solar panel according to an embodiment of the present invention.
[Fig. 2] Fig. 2 is a schematic diagram (top view and bottom view) showing how to evaluate bump absorptivity.
Description of Embodiments

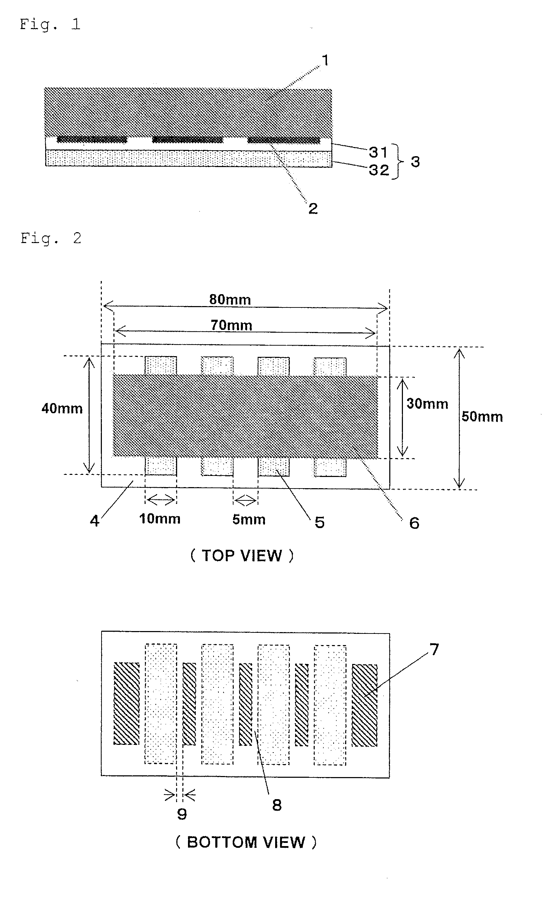

A pressure-sensitive adhesive sheet for a solar panel according to the present invention (hereinafter also simply referred to as a "pressure-sensitive adhesive sheet according to the present invention") is a pressure-sensitive adhesive sheet for use in the manufacture of a solar panel. Specifically, it is a pressure-sensitive adhesive sheet used especially to seal silicon cells (one or more silicon cell(s)) in a thin-film silicon solar panel. Fig. 1 is a schematic cross-sectional view of an exemplary solar panel which includes silicon cells sealed with a pressure-sensitive adhesive sheet for a solar panel according to an embodiment of the present invention. The solar panel includes a glass substrate 1 and silicon cells 2 arranged on the glass substrate 1, in which the silicon cells are sealed by the application of a pressure-sensitive adhesive sheet 3 for a solar panel according to the present invention. The pressure-sensitive adhesive sheet includes a fluorine-containing resin film base 32, and present on one side thereof, a pressure-sensitive adhesive layer 31. As used herein the term "pressure-sensitive adhesive sheet" also includes one in the form of a tape (i.e., a pressure-sensitive adhesive tape).

The pressure-sensitive adhesive sheet according to the present invention includes a fluorine-containing resin film base and a pressure-sensitive adhesive layer present on at least one side of the base. It is generally enough for the pressure-sensitive adhesive sheet to have a pressure-sensitive adhesive layer on only one side of the base. However, the pressure-sensitive adhesive sheet may have pressure-sensitive adhesive layers on both sides of the base.

Exemplary fluorine-containing resins for constituting the fluorine-containing resin film base include, but are not limited to, poly(vinyl fluoride)s, polytetrafluoroethylenes, perfluoroalkoxyalkanes, ethylene-tetrafluoroethylene copolymers, and the like. The pressure-sensitive adhesive sheet according to the present invention adopts a fluorine-containing resin film base and thereby has effectively improved durability.

Though not critical, the film base has a thickness of preferably 5 to 500 $\mu$m, more preferably 10 to 200 $\mu$m, and furthermore preferably 20 to 60 $\mu$m. The film base may have a single-layer structure or multilayer structure. To increase adhesion typically to the pressure-sensitive adhesive layer, the surface of the film base may have been subjected to a common surface treatment such as corona treatment, chromate treatment, exposure to ozone, exposure to flame, exposure to a high-voltage electric shock, treatment with ionizing radiation, or any other chemical or physical oxidization treatment; or may have been subjected to such as a coating treatment typically with a primer and/or a release agent.

A pressure-sensitive adhesive (tacky adhesive) constituting the pressure-sensitive adhesive layer is not specifically limited and can be any of known pressure-sensitive adhesives; and examples thereof include acrylic pressure-sensitive adhesives, rubber pressure-sensitive adhesives, vinyl alkyl ether pressure-sensitive adhesives, silicone pressure-sensitive adhesives, polyester pressure-sensitive adhesives, polyamide pressure-sensitive adhesives, urethane pressure-sensitive adhesives, fluorine-containing pressure-sensitive adhesives, and epoxy pressure-sensitive adhesives. Of these, acrylic pressure-sensitive adhesives and/or rubber pressure-sensitive adhesives are preferred, of which acrylic pressure-sensitive adhesives are more preferred from the viewpoint of providing a high bond strength.

Exemplary rubber pressure-sensitive adhesives include rubber pressure-sensitive adhesives containing a rubber component as a base polymer. Examples of the rubber component include natural rubber, styrene-isoprene-styrene block copolymers (SIS block copolymers), styrene-butadienestyrene block copolymers (SBS block copolymers), styrene-ethylene/butylene-styrene block copolymers (SEBS block copolymers), styrene-butadiene rubbers, polybutadienes, polyisoprenes, polyisobutylenes, isobutylene-isoprene rubbers (butyl rubbers), chloroprene rubbers, silicone rubbers, acrylonitrile-butadiene rubbers, and ethylenepropylene terpolymers.

Exemplary acrylic pressure-sensitive adhesives include pressure-sensitive adhesives containing an acrylic polymer as a base polymer (main component). Of such acrylic polymers, those containing a (meth)acrylic ester as a monomer component are preferred. An alkyl (meth)acrylate is preferably used as a main monomer component constituting the acrylic polymers. The alkyl (meth)acrylate is an alkyl (meth)acrylate having a linear or branched-chain alkyl moiety. Examples of the alkyl (meth)acrylate include alkyl (meth)acrylates whose alkyl moiety having 1 to 20 carbon atoms, such as methyl (meth)acrylates, ethyl (meth)acrylates, propyl (meth)acrylates, isopropyl (meth)acrylates, butyl (meth) acrylates, isobutyl (meth)acrylates, s-butyl (meth)acrylates, t-butyl (meth)acrylates, pentyl (meth)acrylates, isopentyl (meth)acrylates, hexyl (meth)acrylates, heptyl (meth)acrylates, octyl (meth)acrylates, 2-ethylhexyl (meth)acrylates, isooctyl (meth)acrylates, nonyl (meth)acrylates, isononyl (meth)acrylates, decyl (meth)acrylates, isodecyl (meth)acrylates, undecyl (meth)acrylates, dodecyl (meth)acrylates, tridecyl (meth)acrylates, tetradecyl (meth)acrylates, pentadecyl (meth)acrylates, hexadecyl (meth)acrylates, heptadecyl (meth)acrylates, octadecyl (meth)acrylates, nonadecyl (meth) acrylates, and eicosyl (meth)acrylates. Of these, alkyl (meth)acrylates whose alkyl moiety having 2 to 14 carbon atoms are preferred, and alkyl (meth)acrylates whose alkyl moiety having 2 to 10 carbon atoms are more preferred. As used herein the term "(meth)acrylic ester" refers to an "acrylic ester " and/or a "methacrylic ester", and this is true for other descriptions.

Exemplary (meth)acrylic esters other than the alkyl (meth)acrylates include (meth)acrylic esters having an alicyclic hydrocarbon group, such as cyclopentyl (meth)acrylates, cyclohexyl (meth)acrylates, and isobornyl (meth) acrylates; and (meth)acrylic esters having an aromatic hydrocarbon group, such as phenyl (meth)acrylates.

Each of different (meth)acrylic esters can be used alone or in combination. As (meth)acrylic esters are used as a main monomer component constituting an acrylic polymer, the proportion of (meth)acrylic esters [especially alkyl (meth)acrylates] is preferably 60 percent by weight or more, and more preferably 80 percent by weight or more, based on the total amount of monomer components for the preparation of the acrylic polymer.

The acrylic polymer may further contain, as a monomer component, one or more of copolymerizable monomers such as polar-group-containing monomers and multifunctional monomers. The use of such copolymerizable monomers as a monomer component helps the pressure-sensitive adhesive to have an improved bond strength to an adherend and to show an increased cohesive strength. Each of different copolymerizable monomers can be used alone or in combination.

Examples of the polar-group-containing monomers include carboxyl-containing monomers such as (meth) acrylic acids, itaconic acid, maleic acid, fumaric acid, crotonic acid, and isocrotonic acid, and anhydrides of them, such as maleic anhydride; hydroxyl-containing monomers including hydroxylalkyl (meth)acrylates such as hydroxyethyl (meth) acrylates, hydroxypropyl (meth)acrylates, and hydroxybutyl (meth)acrylates; amido-containing monomers such as acrylamide, methacrylamide, N,N-dimethyl(meth)acrylamides, N-methylol(meth)acrylamides, N-methoxymethyl(meth)acrylamides, and N-butoxymethyl(meth)acrylamides; amino-containing monomers such as aminoethyl (meth)acrylates, dimethylaminoethyl (meth)acrylates, and t-butylaminoethyl (meth)acrylates; glycidyl-containing monomers such as glycidyl (meth)acrylates and methylglycidyl (meth)acrylates; cyano-containing monomers such as acrylonitrile and methacrylonitrile; heterocycle-containing vinyl monomers such as N-vinyl-2-pyrrolidone, (meth)acryloylmorpholines, N-vinylpyridine, N-vinylpiperidone, N-vinylpyrimidine, N-vinylpiperazine, N-vinylpyrrole, N-vinylimidazole, and N-vinyloxazole; alkoxyalkyl (meth)acrylate monomers such as methoxyethyl (meth)acrylates and ethoxyethyl (meth)acrylates; sulfo-containing monomers such as sodium vinylsulfonate; phosphate-containing monomers such as 2-hydroxyethylacryloyl phosphate; imido-containing monomers such as cyclohexylmaleimide and isopropylmaleimide; and isocyanate-containing monomers such as 2-methacryloyloxyethyl isocyanate. Of such polar-group-containing monomers, carboxyl-containing monomers such as acrylic acid, or anhydrides of them are preferred.

Such polar-group-containing monomers are used in an amount of 30 percent by weight or less (e.g., 1 to 30 percent by weight), and preferably 3 to 20 percent by weight, based on the total amount of monomer components for constituting the acrylic polymer. Polar-group-containing monomers, if used in an amount of more than 30 percent by weight, may cause an acrylic pressure-sensitive adhesive, for example, to have an excessively high cohesive strength and thereby may cause the pressure-sensitive adhesive layer to have an insufficient tackiness. Polar-group-containing monomers, if used in an excessively small amount (e.g., less than 1 percent by weight), may not exhibit sufficient effects obtained by their copolymerization.

Examples of the multifunctional monomers include hexanediol di(meth)acrylates, butanediol di(meth)acrylates, (poly)ethylene glycol di(meth)acrylates, (poly)propylene glycol di(meth)acrylates, neopentyl glycol di(meth)acrylates, pentaerythritol di(meth)acrylates, pentaerythritol tri(meth)acrylates, dipentaerythritol hexa(meth)acrylates, trimethylolpropane tri(meth)acrylates, tetramethylolmethane tri(meth)acrylates, allyl (meth)acrylates, vinyl (meth)acrylates, divinylbenzene, epoxy acrylates, polyester acrylates, and urethane acrylates.

Multifunctional monomers are used in an amount of 2 percent by weight or less (e.g., 0.01 to 2 percent by weight) and preferably 0.02 to 1 percent by weight, based on the total amount of monomer components for constituting the acrylic polymer. Multifunctional monomers, if used in an amount of more than 2 percent by weight based on the total amount of monomer components for constituting the acrylic polymer, may typically cause the pressure-sensitive adhesive to have an excessively high cohesive strength to thereby have an insufficient tackiness. In contrast, multifunctional monomers, if used in an excessively small amount (e.g., less than 0.01 percent by weight), may not sufficiently exhibit effects obtained by their copolymerization.

Exemplary copolymerizable monomers other than the polar-group-containing monomers and multifunctional monomers include vinyl esters such as vinyl acetate and vinyl propionate; aromatic vinyl compounds such as styrene and vinyltoluenes; olefins or dienes such as ethylene, butadiene, isoprene, and isobutylene; vinyl ethers such as vinyl alkyl ethers; and vinyl chloride.

The base polymer (acrylic polymer in the case of an acrylic pressure-sensitive adhesive) is contained in a content of preferably 80 percent by weight or more, and more preferably 85 to 95 percent by weight, based on the total weight of the pressure-sensitive adhesive layer.

Where necessary, the pressure-sensitive adhesive may further contain appropriate additives. Typically, the pressure-sensitive adhesive may further contain additives appropriately according to the type of the base polymer, and examples of such additives include crosslinking agents such as polyisocyanate crosslinking agents, silicone crosslinking agents, epoxy crosslinking agents, and alkyl-etherified melamine crosslinking agents; tackifiers such as tackifiers which are composed typically of any of rosin derivative resins, polyterpene resins, petroleum resins, and oil-soluble phenol resins and are solid, semisolid, or liquid at normal temperature; polymerization modifiers such as lauryl mercaptan and thioglycolic acid; plasticizers; fillers; age inhibitors; and colorants such as pigments and dyestuffs. The pressure-sensitive adhesive, when being a pressure-sensitive adhesive containing bubbles and/or hollow microspheres as mentioned below, preferably contains a fluorine-containing surfactant as an additive. Though not especially limited, such additives are contained in an amount of preferably 50 parts by weight or less and more preferably 10 parts by weight or less, typically per 100 parts by weight of total monomers for constituting the base polymer [e.g., total monomer components for constituting the acrylic polymer].

An acrylic polymer as the base polymer in the pressure-sensitive adhesive can be prepared by utilizing curing reaction by the action of heat or an active energy ray using a polymerization initiator such as a thermal polymerization initiator and/or photopolymerization initiator (photoinitiator). Of such curing reactions, a curing reaction by the action of an active energy ray using a photoinitiator (photopolymerization) is preferably adopted, because the polymerization time can be shortened and bubbles, when contained in the adhesive, can be stabilized. Each of different polymerization initiators can be used alone or in combination.

Exemplary thermal polymerization initiators include azo polymerization initiators such as 2,2'-azobisisobutyronitrile, 2,2'-azobis-2-methylbutyronitrile, dimethyl 2,2'-azobis(2-methylpropionate), 4,4'-azobis-4-cyanovaleric acid, azobisisovaleronitrile, 2,2'-azobis(2-amidinopropane) dihydrochloride, 2,2'-azobis[2-(5-methyl-2-imidazolin-2-yl)propane] dihydrochloride, 2,2'-azobis(2-methylpropionamidine) disulfate, and 2,2'-azobis(N,N'-dimethyleneisobutylamidine) dihydrochloride; peroxide polymerization initiators such as dibenzoyl peroxide and tert-butyl permaleate; and redox polymerization initiators. The amount of thermal polymerization initiators is not critical, as long as being a customary amount within such a range as to be usable as thermal polymerization initiators.

Exemplary photoinitiators usable herein include, but are not especially limited to, benzoin ether photoinitiators, acetophenone photoinitiators, $\alpha$-ketol photoinitiators, aromatic sulfonyl chloride photoinitiators, photoactive oxime photoinitiators, benzoin photoinitiators, benzil photoinitiators, benzophenone photoinitiators, ketal photoinitiators, and thioxanthone photoinitiators.

Specifically, exemplary benzoin ether photoinitiators include benzoin methyl ether, benzoin ethyl ether, benzoin propyl ether, benzoin isopropyl ether, benzoin isobutyl ether, 2,2-dimethoxy-1,2-diphenylethan-1-one, and anisole methyl ether. Exemplary acetophenone photoinitiators include 2,2-diethoxyacetophenone, 2,2-dimethoxy-2-phenylacetophenone, 1-hydroxycyclohexyl phenyl ketone, 4-phenoxydichloroacetophenone, and 4-(t-butyl)dichloroacetophenone. Exemplary $\alpha$-ketol photoinitiators include 2-methyl-2-hydroxypropiophenone and 1-[4-(2-hydroxyethyl)phenyl]-2-methylpropan-1-one. Exemplary aromatic sulfonyl chloride photoinitiators include 2-naphthalenesulfonyl chloride. Exemplary photoactive oxime photoinitiators include 1-phenyl-1,1-propanedione-2-(o-ethoxycarbonyl)-oxime.

Exemplary benzoin photoinitiators include benzoin. Exemplary benzil photoinitiators include benzil (dibenzoyl). Exemplary benzophenone photoinitiators include benzophenone, benzoylbenzoic acid, 3,3'-dimethyl-4-methoxybenzophenone, polyvinylbenzophenone, and $\alpha$-hydroxycyclohexyl phenyl ketone. Exemplary ketal photoinitiators include benzil dimethyl ketal. Exemplary thioxanthone photoinitiators include thioxanthone, 2-chlorothioxanthone, 2-methylthioxanthone, 2,4-dimethylthioxanthone, isopropylthioxanthone, 2,4-diisopropylthioxanthone, and dodecylthioxanthone.

Though not critical, such photoinitiators can be used in an amount within a range of typically 0.01 to 5 parts by weight and preferably 0.05 to 3 parts by weight, per 100 parts by weight of total monomer components for constituting the base polymer in the pressure-sensitive adhesive [e.g., total monomer components for constituting the acrylic polymer].

An active energy ray is applied for the activation of the photoinitiators. Exemplary active energy rays include ionizing radiation such as alpha ray, beta ray, gamma ray, neutron beams, and electron beams; and ultraviolet rays, of which ultraviolet rays are preferred. Irradiation conditions of the active energy ray, such as irradiation energy and irradiation time, are not especially limited, as long as the photoinitiators are activated to cause reaction of monomer components.

The pressure-sensitive adhesive layer in the pressure-sensitive adhesive sheet according to the present invention is preferably a pressure-sensitive adhesive layer formed from a pressure-sensitive adhesive containing bubbles and/or hollow microspheres. Such a pressure-sensitive adhesive containing at least one of bubbles and hollow microspheres is preferred, because the pressure-sensitive adhesive sheet shows improved fittability to curved surfaces, bumps, and uneven surfaces and thereby shows improved adhesive performance, and this allows the pressure-sensitive adhesive sheet to have improved sealing performance for sealing silicon cells. Hereinafter such a pressure-sensitive adhesive (pressure-sensitive adhesive layer) containing bubbles and/or hollow microspheres is generically referred to as a "bubble-containing pressure-sensitive adhesive (pressure-sensitive adhesive layer)".

Though may be chosen appropriately within such a range as not impairing, for example, adhesive performance, the amount of bubbles to be contained in the bubble-containing pressure-sensitive adhesive layer is generally 5 to 50 percent by volume, preferably 10 to 40 percent by volume, and more preferably 12 to 30 percent by volume, based on the total volume of the bubble-containing pressure-sensitive adhesive layer. A bubble-containing pressure-sensitive adhesive layer, if containing bubbles in an amount of less than 5 percent by volume, may not sufficiently exhibit a stress relaxation function and may thereby be insufficient in bump absorptivity and adhesiveness. In contrast, a bubble-containing pressure-sensitive adhesive layer, if containing bubbles in an amount of more than 50 percent by volume, may suffer from the formation of bubbles penetrating the pressure-sensitive adhesive layer and may thereby show insufficient adhesiveness or may become excessively flexible (soft).

The bubbles to be contained in the bubble-containing pressure-sensitive adhesive layer are basically preferably closed cells but may be a mixture of closed cells and open cells.

The bubbles are generally spheroidal, but they may be irregular spheroidal. The average diameter of the bubbles is not particularly limited and may be chosen within ranges of typically 1 to 1000 $\mu$m, preferably 10 to 500 $\mu$m, and more preferably 30 to 300 $\mu$m.

Examples of a gas component (gaseous component constituting bubbles; hereinafter also referred to as a "bubble-constituting gas") contained in the bubbles include, but are not limited to, inert gases such as nitrogen, carbon dioxide, and argon gases; and other various gaseous components such as air. When a bubble-constituting gas is incorporated typically before carrying out a reaction such as polymerization reaction, the bubble-constituting gas should be one that does not adversely affect the reaction. Nitrogen is preferably used as the bubble-constituting gas, typically because it is inert to such reactions and low in cost.

The use of hollow microspheres as one of components constituting the bubble-containing pressure-sensitive adhesive layer helps the bubble-containing pressure-sensitive adhesive layer, for example, to have further increased bump absorptivity and shear bond strength and to show further improved workability. Each of different types of hollow microspheres can be used alone or in combination.

The hollow microspheres may be either hollow inorganic microspheres or hollow organic microspheres. Specifically, of hollow microspheres, exemplary hollow inorganic microspheres include hollow balloons made of glass, such as hollow glass balloons; hollow balloons made of metallic compounds, such as hollow alumina balloons; and hollow balloons made of ceramics or porcelain, such as hollow ceramic balloons. Exemplary hollow organic microspheres include hollow balloons made from resins, such as hollow acrylic balloons and hollow poly(vinylidene chloride) balloons.

Though not critical, the hollow microspheres have a particle size (average particle diameter) selectable within a range typically of 1 to 500 $\mu$m, preferably 5 to 200 $\mu$m, and furthermore preferably 10 to 100 $\mu$m.

Though not critical, the hollow microspheres have a specific gravity selectable within a range of typically 0.1 to 0.8 g/cm$^3$ and preferably 0.12 to 0.5 g/cm$^3$. Hollow microspheres, if having a specific gravity of less than 0.1 g/cm$^3$, may be difficult to be uniformly dispersed in a bubble-containing pressure-sensitive adhesive composition, because they may undesirably float up during mixing with other components of the composition. In contrast, hollow microspheres, if having a specific density of more than 0.8 g/cm$^3$, may be excessively expensive and cause increase in cost.

Though not critical, the amount of hollow microspheres used is an amount selectable within such a range that the amount of the hollow microspheres based on the total volume of the bubble-containing pressure-sensitive adhesive layer be 5 to 50 percent by volume, preferably 10 to 50 percent by volume, and furthermore preferably 15 to 40 percent by volume. Hollow microspheres, if present in the composition in such an amount that the amount in the pressure-sensitive adhesive layer is less than 5 percent by volume, may exhibit their addition effects insufficiently. In contrast, hollow microspheres, if present in the composition in such an amount that the amount in the pressure-sensitive adhesive layer is more than 50 percent by volume, may adversely affect the bond strength of the pressure-sensitive adhesive layer.

A pressure-sensitive adhesive composition for use in the present invention for the formation of a pressure-sensitive adhesive layer (including a bubble-containing pressure-sensitive adhesive layer) can be prepared by blending, according to a known technique, one or more monomer components (e.g., (meth)acrylic esters) constituting the base polymer of the pressure-sensitive adhesive, one or more polymerization initiators, and various additives with each other. Where necessary typically for the adjustment of viscosity, the monomer components may be partially polymerized. Typically, partial polymerization (in the case of photopolymerization) may be performed in the following manner: (i) One or more monomer components (e.g., (meth)acrylic esters and other copolymerizable monomers) for the formation of the base polymer, and one or more photoinitiators are mixed to give a monomer mixture; and (ii) the monomer mixture is subjected to photopolymerization (e.g., polymerization by the action of an ultraviolet ray) to give a composition (syrup) in which only part of the monomer components is polymerized. Next, (iii) the resulting syrup is combined with other components such as hollow microspheres, fluorine-containing surfactants, and other additives according to necessity to give a blend. When bubbles are to be contained in the pressure-sensitive adhesive, (iv) bubbles are introduced and mixed with the blend obtained in the step (iii) to give a bubble-containing pressure-sensitive adhesive composition. The way to prepare such a bubble-containing pressure-sensitive adhesive composition is not limited to the above procedure, and the composition may be prepared, for example, by previously incorporating fluorine-containing surfactants and/or hollow microspheres into the monomer mixture before the preparation of the syrup.

Bubbles, when to be contained in the pressure-sensitive adhesive layer, are preferably incorporated as the last component into the pressure-sensitive adhesive composition as in the above preparation procedure. This helps the bubbles to be stably incorporated and stably present in the pressure-sensitive adhesive layer. A blend (precursor composition) before incorporation of bubbles (e.g., the blend prepared from the step (iii)) preferably has a higher viscosity, so as to hold the mixed bubbles stably. Though not critical, the blend before incorporation of bubbles has a viscosity of, for example, preferably 5 to 50 Pa·s, and more preferably 10 to 40 Pa·s, as measured at a temperature of 30°C using a BH type viscometer with a No. 5 rotor at a number of revolutions of 10 rpm. The blend, if having an excessively low viscosity of less than 5 Pa·s, may not satisfactorily hold bubbles, because incorporated bubbles may immediately coalesce to escape out of the system. In contrast, the blend, if having an excessively high viscosity of more than 50 Pa·s, may be difficult to give a pressure-sensitive adhesive layer satisfactorily through coating. The viscosity of the blend can be controlled, for example, by incorporating various polymer components such as acrylic rubbers and thickening additives; and/or by partially polymerizing monomer components for constituting the base polymer.

The way to incorporate bubbles in the preparation of the bubble-containing pressure-sensitive adhesive composition is not especially limited and may be any known process for mixing such bubbles into compositions. An exemplary device for use herein is one that includes a stator and a rotor, in which the stator includes a disc having a through hole at the center part and having a multiplicity of fine teeth thereon, and the rotor faces the stator and includes a disc having a multiplicity of fine teeth thereon, as in the stator. Using this device, the blend to which bubbles are to be contained is introduced in between the teeth of the stator and the teeth of the rotor, and a gaseous component for constituting bubbles (bubble-constituting gas) is introduced via the through hole into the blend while rotating the rotor at high speed, to thereby give a bubble-containing pressure-sensitive adhesive composition containing finely divided and dispersed bubble-constituting gas.

To suppress or prevent coalescence of bubbles, it is desirable to carry out the steps from the incorporation of bubbles to the formation of the pressure-sensitive adhesive layer continuously as a series of steps. Specifically, it is desirable that a bubble-containing pressure-sensitive adhesive composition is prepared while incorporating bubbles thereinto in the above way, and the formed pressure-sensitive adhesive composition is immediately subjected to the formation of the bubble-containing pressure-sensitive adhesive layer.

The pressure-sensitive adhesive sheet for a solar panel according to the present invention includes the pressure-sensitive adhesive layer present on at least one side of the fluorine-containing resin film base, as described above. Specifically, regarding structure thereof, embodiments of the pressure-sensitive adhesive sheet according to the present invention include (1) a single-sided pressure-sensitive adhesive sheet structurally including a film base and a pressure-sensitive adhesive layer present on only one side of the film base and containing or not containing bubbles; (2) a double-sided pressure-sensitive adhesive sheet structurally including a film base, a bubble-containing pressure-sensitive adhesive layer on one side of the film base, and a pressure-sensitive adhesive layer containing no bubbles on the other side of the film base; and (3) a double-sided pressure-sensitive adhesive sheet structurally including a film base and a pressure-sensitive adhesive layer present on both sides of the film base and containing or not containing bubbles. A single-sided pressure-sensitive adhesive sheet of the structure (1) is generally preferably adopted.

The pressure-sensitive adhesive sheet according to the present invention may be wound into a roll or may be stacked as sheets. Specifically, the pressure-sensitive adhesive sheet according to the present invention can be in the form typically of a sheet or tape. The adhesive face of the pressure-sensitive adhesive sheet, if wound as a roll, may be protected by a release film (separator).

Though not especially limited, exemplary processes for the formation of a pressure-sensitive adhesive layer on a film base in the pressure-sensitive adhesive sheet according to the present invention include a direct application process of applying a pressure-sensitive adhesive composition onto a film base to form a coating layer and curing the coating layer by the action of an active energy ray; and a transfer process of applying a pressure-sensitive adhesive composition onto a suitable carrier such as release film (separator) to give a coating layer, curing the coating layer in the same manner as above to give a pressure-sensitive adhesive layer, and transferring the pressure-sensitive adhesive layer to a film base.

Though not critical, the pressure-sensitive adhesive layer has a thickness of, for example, preferably 50 to 5000 $\mu$m, more preferably 200 to 2000 $\mu$m, and furthermore preferably 300 to 1200 $\mu$m. The pressure-sensitive adhesive layer, if having a thickness of less than 50 $\mu$m, may have insufficient cushioning properties and may cause the pressure-sensitive adhesive sheet to show insufficient adhesiveness to bumps. In contrast, the pressure-sensitive adhesive layer, if having a thickness of more than 5000 $\mu$m, may be difficult to have a uniform thickness and thereby be difficult to give a pressure-sensitive adhesive sheet having a uniform thickness. The pressure-sensitive adhesive layer may have a single-layer structure or multilayer structure.

The pressure-sensitive adhesive sheet according to the present invention may further include a release film (separator) to protect the surface (adhesive face) of the pressure-sensitive adhesive layer before use. The separator is removed when the adhesive face which has been protected by the separator is used. Specifically, it is removed when the pressure-sensitive adhesive sheet is applied to seal silicon cells.

The separator can for example be a customary release paper. Specifically, exemplary separators usable herein include separators composed of a separator base material and a release coating layer formed by a release coating agent (parting agent) and present on at least one side of the base material; separators composed of a base material having low adhesiveness and made from any of fluorine-containing polymers (e.g., polytetrafluoroethylenes, polychlorotrifluoroethylenes, poly(vinyl fluoride)s, poly(vinylidene fluoride)s, tetrafluoroethylene-hexafluoropropylene copolymers, and chlorofluoroethylene-vinylidene fluoride copolymers); and separators composed of a base material having low adhesiveness and made from any of nonpolar polymers (e.g., olefinic resins such as polyethylenes and polypropylenes).

The separator for use herein is preferably a separator including a base material for separator (separator base material) and a release coating layer present on at least one side of the base material. Exemplary separator base materials include plastic base films (synthetic resin films) such as polyester films (e.g., poly(ethylene terephthalate) films), olefinic resin films (e.g., polyethylene films and polypropylene films), poly(vinyl chloride) films, polyimide films, polyamide films (nylon films), and rayon films; papers (e.g., woodfree paper, Japanese paper, kraft paper, glassine paper, synthetic paper, and topcoat paper); and laminates (multilayer assemblies having two or three layers) of these materials prepared typically through lamination or coextrusion. Exemplary release coating agents for constituting the release coating layer include, but are not limited to, silicone release coating agents, fluorine-containing release coating agents, long-chain alkyl release coating agents, and the like. Each of different release agents may be used alone or in combination.

The pressure-sensitive adhesive sheet according to an embodiment of the present invention can be affixed to glass under an ordinary condition (23°C, 50% relative humidity). Specifically, the phrase "can be affixed under an ordinary condition" refers to that an adhesive face (adhesive face to be used for sealing silicon cells) of the pressure-sensitive adhesive sheet has an adhesive strength (peel force) to a slide glass (180-degree peel, at a tensile speed of 300 mm/min) of 15 newtons per 20 millimeters (N/20 mm) or more, and preferably 30 N/20 mm or more under a condition at a temperature of 23°C and relative humidity of 50%. As is described above, the pressure-sensitive adhesive sheet according to the present invention can be affixed to a glass substrate under an ordinary condition, thereby does not require hot pressing of the pressure-sensitive adhesive layer for the sealing of silicon cells, does not suffer from damage typically to the wiring, does not cause process contamination due to squeezing out of the pressure-sensitive adhesive layer, does not require heating facilities, and is thus advantageous in productivity and cost.

A pressure-sensitive adhesive sheet according to a preferred embodiment of the present invention has satisfactory bump absorptivity (fittability to uneven surfaces; fittability around bumps). The pressure-sensitive adhesive sheet having such satisfactory bump absorptivity exhibits further higher sealing properties with respect to silicon cells. This suppresses the failure of cells caused by external force or the corrosion of cells caused by invasion of water and thereby helps the solar panel to have higher long-term reliability. The bump absorptivity can be controlled typically by the composition of the pressure-sensitive adhesive composition. In this connection, the pressure-sensitive adhesive layer is preferably a bubble-containing pressure-sensitive adhesive layer for dramatically higher bump absorptivity.

A pressure-sensitive adhesive sheet according to another preferred embodiment of the present invention has excellent weatherability for ensuring long-term durability and reliability of the solar panel. Specifically, the weatherability is evaluated by whether adhesiveness lowers and whether discoloration occurs in an outdoor exposure test (for 2400 hours). The outdoor exposure test will be described in detail later. The weatherability can be obtained by adopting a fluorine-containing film as the base.

The pressure-sensitive adhesive sheet according to the present invention includes a fluorine-containing resin film base and thereby has excellent water vapor barrier properties. Specifically, the pressure-sensitive adhesive sheet has a water vapor transmission rate of preferably 5 (g/m$^2$·day) or less, and more preferably 1 (g/m$^2$·day) or less. The pressure-sensitive adhesive sheet, if having a water vapor transmission rate of more than 5 (g/m$^2$·day), may suffer from invasion of water to cause corrosion of the cells, and this may cause the solar panel to show insufficient long-term durability and reliability.

The pressure-sensitive adhesive sheet according to the present invention enables the sealing of silicon cells at normal temperature and does not require hot pressing, in contrast to the EVA resins commonly used as sealing resins for solar panels. The pressure-sensitive adhesive sheet thereby does not cause wiring damage and process contamination due to hot pressing and is also advantageous in cost. The pressure-sensitive adhesive sheet includes a fluorine-containing resin film base, thereby shows excellent water vapor barrier properties and has good weatherability. The pressure-sensitive adhesive sheet, if having a pressure-sensitive adhesive layer containing bubbles and/or hollow microspheres, shows especially satisfactory bump absorptivity and thereby has further improved sealing properties with respect to silicon cells.

The pressure-sensitive adhesive sheet for a solar panel according to the present invention is used to seal silicon cells (one or more silicon cell(s)) arranged on a glass substrate to give a solar panel. Specifically, the solar panel is manufactured by forming thin-film silicon solar cells (silicon cells) on a glass substrate according typically to a known or common method for manufacturing a thin-film solar cell module; and affixing the pressure-sensitive adhesive sheet according to the present invention to the glass substrate so that the adhesive face is in contact with the side of the glass substrate where the silicon cells are formed. The step of affixing the pressure-sensitive adhesive sheet can be performed at relatively low temperatures (e.g., from about 10°C to about 40°C).

[Methods for Determining Properties]

(1) Adhesive Strength

An adherend used herein was "MICRO GLASS Suienma S-1214" (76 mm long, 26 mm wide, 1.2 mm thick) supplied by Matsunami Glass Ind., Ltd.
A sample pressure-sensitive adhesive sheet 20 mm wide was affixed to the adherend through compression bonding with one reciprocating movement of a 2-kg roller under a condition of 23°C and 50% relative humidity to give a specimen. The 180-degree peel force (N/20 mm) of the sample was measured at a tensile speed of 300 mm/min with a tensile tester initially (30 minutes after the affixation) and 5 days later.

(2) Bump Absorptivity

As illustrated in Fig. 2, four pieces of a 10-mm wide poly(ethylene terephthalate) plate 5 (thickness: 12 $\mu$m) were arranged at intervals of 5 mm wide and fixed on a transparent acrylic plate 4; a pressure-sensitive adhesive sheet 6 (30 mm x 70 mm) obtained in an example below was affixed thereon through one reciprocating movement of a 5-kg roller (50 mm wide) so that the adhesive face of the pressure-sensitive adhesive sheet was in contact with the poly (ethylene terephthalate) plates. Immediately after the affixation, how the pressure-sensitive adhesive sheet was in intimate contact with the acrylic plate was observed from the backside (acrylic plate side) with an optical microscope. The widths (the reference numeral "9" in Fig. 2) of portions 8 at edges of the poly(ethylene terephthalate) plate where the pressure-sensitive adhesive sheet was not in intimate contact with the acrylic plate were measured, and the eight measured widths were averaged. When the sample had an average width of 0.1 mm or less, it was evaluated as having good bump absorptivity (Good), whereas when the sample had an average width of more than 0.1 mm, it was evaluated as having poor bump absorptivity (Poor).
The reference numeral "7" in Fig. 2 represents a portion where the pressure-sensitive adhesive sheet and the acrylic plate are in intimate contact with each other.

(3) Weatherability

The pressure-sensitive adhesive sheet obtained in the example was affixed to the slide glass and exposed to outdoor (Outdoor exposure testing place, Nitto Denko Corporation, Toyohashi-shi, Aichi Pref., Japan; for 2400 hours) to give a sample.
The sample was evaluated on adhesiveness and discoloration according to the following methods.

(Adhesiveness)

The sample was visually observed to determine whether lifting/peeling occurred or not. When the sample showed no lifting/peeling, it was evaluated as having good weatherability (Good), whereas when the sample showed lifting/peeling, it was evaluated as having poor weatherability (Poor).

(Discoloration)

The sample was visually observed to determine whether discoloration occurred or not. When the sample showed no discoloration, it was evaluated as having good weatherability (Good), whereas when the sample showed discoloration, it was evaluated as having poor weatherability (Poor).

(4) Water Vapor Transmission Rate (Water Vapor Barrier Properties) (Dish Method)

A test sample was subjected to a test according to Japanese Industrial Standards (JIS) Z 0208 under conditions of 40°C and 90% relative humidity for 30 days, and the water vapor transmission rate of the test sample was determined according to the following equation. The test sample was prepared by removing the separator from the pressure-sensitive adhesive sheet obtained in the example.

$$Q=q/(A×t)$$

Q: Water vapor transmission rate (g/m$^2$·day)
q: Amount (g) of water vapor transmitting the test piece
A: Water vapor permeation area (m$^2$)
t: Time (day)

A water vapor permeability cup used in the measurement was an aluminum cup having an inner diameter of 70 mm and a height of 20 mm, and the permeation area of the sample had a size of 56.5 mm in diameter.

EXAMPLES

The present invention will be illustrated in further detail with reference to a working example below. It should be noted, however, that this example is never construed to limit the scope of the present invention. The properties of the pressure-sensitive adhesive sheet obtained in the example were determined according to the above methods and are shown in Table 1.

EXAMPLE 1

A partially polymerized composition (syrup) was prepared by blending 90 parts by weight of 2-ethylhexyl acrylate with 10 parts by weight of acrylic acid both as monomer components to give a monomer mixture; mixing the monomer mixture with photoinitiators, i.e., 0.05 part by weight of the trade name "IRGACURE 651" (supplied by Ciba Specialty Chemicals Corporation) and 0.05 part by weight of the trade name "IRGACURE 184" (supplied by Ciba Specialty Chemicals Corporation); and applying an ultraviolet ray to the resulting mixture to a viscosity of about 15 Pa·s. The viscosity was measured with a BH type viscometer using a No. 5 rotor at 10 rpm and at a measurement temperature of 30°C.
The syrup was combined with 0.1 part by weight of 1,6-hexanediol diacrylate and further combined with hollow glass balloons under the trade name "CEL-STAR Z-27" (supplied by Tokai Kogyo Co., Ltd.) in an amount of 30 parts by volume per 100 parts by volume of the total volume of the syrup. The syrup was further combined with 0.2 part by weight of a fluorine-containing surfactant under the trade name "EFTOP EF-352" (supplied by JEMCO Inc.) and thereby yielded a pressure-sensitive adhesive precursor. The pressure-sensitive adhesive precursor had a volume of hollow glass balloons of about 23 percent by volume based on the total volume of the pressure-sensitive adhesive precursor.
Bubbles were introduced into the pressure-sensitive adhesive precursor by feeding the precursor and introducing nitrogen into a device. This device includes a stator and a rotor, in which the stator includes a disc having a through hole at the center part and having a multiplicity of fine teeth thereon, and the rotor faces the stator with the teeth and includes a disc having a multiplicity of fine teeth thereon as in the stator. The bubbles were introduced into the precursor to an amount of about 15 percent by volume based on the total volume of a discharged composition. Thus, a bubble-containing pressure-sensitive adhesive composition was prepared.
Next, the bubble-containing pressure-sensitive adhesive composition was applied to a releasably treated surface of a poly(ethylene terephthalate) (PET) base (separator) so as to give a coat with a thickness after curing of 0.8 mm, in which the PET base had the releasably treated surface on one side thereof. Another PET base having a releasably treated surface (separator) was applied to the coat so that the releasably treated surface thereof was in contact with the coat. The resulting article was irradiated with an ultraviolet ray (UV) at an illuminance of about 4.0 mW/cm$^2$ for 10 minutes to cure the bubble-containing pressure-sensitive adhesive composition to thereby give a bubble-containing pressure-sensitive adhesive layer having a thickness of 0.8 mm. One of the two PET bases was removed, and the exposed bubble-containing pressure-sensitive adhesive layer was superimposed on one side of a fluorine-containing resin film ("Tedler Film TGH15BL3" supplied by Du Pont) 38 μm thick and thereby yielded a pressure-sensitive adhesive sheet having a multilayer structure of (separator)/(bubble-containing pressure-sensitive adhesive layer)/(fluorine-containing resin base film).

Table 1 demonstrates that the pressure-sensitive adhesive sheet excelled in adhesive strength (adhesive properties) to glass under an ordinary condition, bump absorptivity, and weatherability, also excelled in water vapor barrier properties with a low water vapor transmission rate, and was advantageous as a pressure-sensitive adhesive sheet for a solar panel.

[Table 1]

(Table 1)

|  |  | Example 1 |
|---|---|---|
| Adhesive strength (initial) (N/20 mm) |  | 31.9 (adhesive failure) |
| Adhesive strength (5 days later) (N/20 mm) |  | 44.5 (cohesive failure) |
| Bump absorptivity |  | Good |
| Water vapor transmission rate (g/m$^2$·day) |  | 0.73 |
| Weatherability | Adhesiveness | Good |
|  | Appearance (discoloration) | Good |

Industrial Applicability

The pressure-sensitive adhesive sheet for a solar panel according to the present invention, when used to seal silicon cells, enables the manufacture of a solar panel while avoiding wiring damage and process contamination caused by vacuum hot pressing. The pressure-sensitive adhesive sheet excels in water vapor barrier properties and shows good weatherability because of having a fluorine-containing resin film base. In addition, the pressure-sensitive adhesive sheet, when having a pressure-sensitive adhesive layer containing bubbles and/or hollow microspheres, especially excels in bump absorptivity and can thereby act to seal silicon cells more satisfactorily. For these reasons, the pressure-sensitive adhesive sheet is useful in the manufacture of a solar panel and especially useful in the sealing of silicon cells in a thin-film silicon solar panel.

Reference Signs List

1      glass substrate
2      silicon cell
3      pressure-sensitive adhesive sheet for solar panel
31     pressure-sensitive adhesive layer
32     fluorine-containing resin film base
4      transparent acrylic plate
5      poly(ethylene terephthalate) (PET) plate
6      pressure-sensitive adhesive sheet (sample)
7      portion where pressure-sensitive adhesive sheet and acrylic plate are in intimate contact with each other
8      portion where pressure-sensitive adhesive sheet and acrylic plate are not in intimate contact with each other
9      width (target for measurement) of portion where pressure-sensitive adhesive sheet and acrylic plate are not in intimate contact with each other

**Claims**

1. A pressure-sensitive adhesive sheet for a solar panel, adopted to the sealing of a silicon cell in the solar panel, the pressure-sensitive adhesive sheet comprising a fluorine-containing resin film base and a pressure-sensitive adhesive layer present on at least one side of the film base.

2. The pressure-sensitive adhesive sheet for a solar panel, according to Claim 1, wherein the pressure-sensitive adhesive layer comprises an acrylic pressure-sensitive adhesive and/or a rubber pressure-sensitive adhesive.

3. The pressure-sensitive adhesive sheet for a solar panel, according to one of Claims 1 and 2, wherein the pressure-sensitive adhesive layer is a bubble-containing pressure-sensitive adhesive layer containing bubbles and/or hollow microspheres.

4. A solar panel comprising the pressure-sensitive adhesive sheet for a solar panel as defined in any one of claims 1 to 3, the pressure-sensitive adhesive sheet sealing a silicon cell, the silicon cell present on a glass substrate.

5. A method for manufacturing a solar panel, the method comprising the step of sealing a silicon cell present on a glass substrate with the pressure-sensitive adhesive sheet for a solar panel as defined in any one of Claims 1 to 3.

Fig. 1

Fig. 2

( TOP VIEW )

( BOTTOM VIEW )

## INTERNATIONAL SEARCH REPORT

| | International application No. |
|---|---|
| | PCT/JP2009/001754 |

A.  CLASSIFICATION OF SUBJECT MATTER
*H01L31/042*(2006.01)i, *C09J7/02*(2006.01)i, *C09J121/00*(2006.01)i,
*C09J133/04*(2006.01)i

According to International Patent Classification (IPC) or to both national classification and IPC

B.  FIELDS SEARCHED

Minimum documentation searched (classification system followed by classification symbols)
H01L31/042, C09J7/02, C09J121/00, C09J133/04

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y | JP 2001-267608 A  (Canon Inc.),<br>28 September, 2001 (28.09.01),<br>Par. Nos. [0035] to [0042]; Fig. 1(b)<br>(Family: none) | 1,4-5<br>2-3 |
| X<br>Y | JP 2002-305316 A  (Canon Inc.),<br>18 October, 2002 (18.10.02),<br>Par. Nos. [0011] to [0012]; Fig. 10<br>(Family: none) | 1<br>2-5 |
| X<br>Y | JP 2001-284627 A  (Canon Inc.),<br>12 October, 2001 (12.10.01),<br>Par. No. [0144]; Fig. 6<br>(Family: none) | 1<br>2-5 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 July, 2009 (14.07.09) | 28 July, 2009 (28.07.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/001754

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2005-200958 A (East Japan Railway Co.), 28 July, 2005 (28.07.05), Par. Nos. [0028], [0042], [0048] & KR 10-2005-0075728 A & CN 1664260 A | 2-3 |

Form PCT/ISA/210 (continuation of second sheet) (April 2007)

| **INTERNATIONAL SEARCH REPORT** | International application No. |
|---|---|
| | PCT/JP2009/001754 |

**Box No. II        Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III        Observations where unity of invention is lacking (Continuation of item 3 of first sheet)**

This International Searching Authority found multiple inventions in this international application, as follows:

```
    Since a result of the search shows that a feature common to the
inventions in claims 1-5 is disclosed in JP 2001-267608, it has become
clear that the common feature is not novel.

    As a result, since the common feature does not make any contribution
over the prior art, the feature is not the special technical feature
in the meaning of PCT Rule 13.2, second sentence.

                                          (Continued to extra sheet)
```

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**INTERNATIONAL SEARCH REPORT**

International application No.

PCT/JP2009/001754

Continuation of Box No.III of continuation of first sheet(2)

Further, since there are no common features deemed to be the special technical feature in the meaning of PCT Rule 13.2, second sentence, no technical relationships in the meaning of PCT Rule 13 can be found among those different inventions.

Therefore, the inventions in claims 1-5 do not comply with the requirement of unity of invention.

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003110128 A